(19) Europäisches Patentamt / European Patent Office / Office européen des brevets

(11) **EP 3 949 120 B1**

(12) **EUROPEAN PATENT SPECIFICATION**

(45) Date of publication and mention
of the grant of the patent:
**27.03.2024 Bulletin 2024/13**

(21) Application number: **20710981.0**

(22) Date of filing: **19.03.2020**

(51) International Patent Classification (IPC):
*H03H 9/64* (2006.01)    *G01K 11/26* (2006.01)
*G01S 7/03* (2006.01)    *G01S 13/88* (2006.01)

(52) Cooperative Patent Classification (CPC):
**H03H 9/642; G01K 11/265;** G01S 7/03; G01S 13/88

(86) International application number:
**PCT/EP2020/057612**

(87) International publication number:
**WO 2020/200809 (08.10.2020 Gazette 2020/41)**

(54) **INTERROGATION OF ACOUSTIC WAVE SENSORS**

ABFRAGE VON AUF AKUSTISCHEN WELLEN BASIERENDEN SENSOREN

INTERROGATION DE CAPTEURS À ONDES ACOUSTIQUES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.03.2019 FR 1903331**

(43) Date of publication of application:
**09.02.2022 Bulletin 2022/06**

(73) Proprietor: **Soitec**
**38190 Bernin (FR)**

(72) Inventors:
• **BALLANDRAS, Sylvain**
**25000 Besaçon (FR)**

• **GARCIA, Julien**
**39380 Chamblay (FR)**

(74) Representative: **Grünecker Patent- und
Rechtsanwälte
PartG mbB
Leopoldstraße 4
80802 München (DE)**

(56) References cited:
WO-A1-2005/080099    US-A1- 2010 250 170
US-A1- 2011 159 817

**Description**

The present invention relates to passive sensors of the acoustic wave type and, in particular, the interrogation of a passive surface acoustic wave or bulk acoustic wave sensor.

Sensors are of growing importance and become more and more ubiquitous in every-day life. Micro-electromechanical systems (MEMS) are an attractive option to answer the demand for increased performance of sensors along with decreased sizes and costs. Surface acoustic wave (SAW) sensors , and to a lower extent bulk acoustic wave (BAW) sensors or Lamb wave or Love wave acoustic sensors, offer particularly advantageous options due to a wide variety of measurable ambient parameters including temperature, pressure, strain and torque, for example.

Acoustic wave sensors utilize the piezoelectric effect to transduce an electrical signal into a mechanical / acoustic wave. SAW-based sensors are built on single-crystal piezoelectric materials like quartz ($SiO_2$), lithium niobate ($LiNbO_3$), lithium tantalate ($LiTaO_3$), langasite (LGS) or poly-crystal piezoelectric materials like aluminum nitride (AIN) or zinc oxide (ZnO), in particular, deposited on silicon, or even on a Piezo-On-Insulator (POI) composite material comprising a layer of piezoelectric material, in particular, a single-crystal material, such as, for example, lithium tantalate or lithium niobate, bonded to a support substrate as for instance silicon, if necessary by means of a bonding layer, as for instance a silicon oxide layer (in general, any combination of a single crystal piezoelectric material with non-piezoelectric substrates used for their specific properties like thermal stability or acoustic quality). A transducer, in the case of a surface acoustic wave sensor, an interdigitated transducer (IDT), converts the electrical energy of the electrical signal into acoustic wave energy. The acoustic wave travels across the surface (or bulk) of a device substrate via the so-called delay line to another transducer, in particular, an IDT, that converts the acoustic wave back to an electrical signal that can be detected. In some devices mechanical absorbers and/or reflectors are provided in order to prevent interference patterns and reduce insertion loss. In some devices the other (output) IDT is replaced by a reflector that reflects the generated acoustic wave back to the (input) IDT that can be coupled to an antenna for remote interrogation of the sensor device. Advantageously, the measurements can be performed completely passively, i.e., the sensor has not to be powered by a power source.

A particular class of acoustic sensors comprises resonators exhibiting resonance frequencies that vary according to varying ambient conditions. A conventional surface wave resonator, for example, comprises an electroacoustic transducer with interdigitated combs arranged between Bragg mirrors. At the resonance frequency, the condition of synchronism between the reflectors is satisfied making it possible to obtain a coherent addition of the different reflections which occur under the reflectors.

A maximum of acoustic energy is then observed within the resonant cavity and, from an electrical point of view, a maximum of amplitude of the current admitted by the transducer is observed. Differential acoustic wave sensors may comprise two or more resonators exhibiting different resonance frequencies or a resonator working in multimode (several resonance frequencies), wherein differences in the measured frequencies reflect variations in the ambient parameters as, for example, temperature or strain (cf. US2010/250170).

However, despite the recent engineering process, the entire interrogation process wherein an interrogator transmits an appropriate radiofrequency signal that is received by the acoustic wave sensor via a reception antenna and converted by a transducer into a surface acoustic wave (or bulk wave, in the case of devices of a bulk acoustic wave sensor type) propagating along a delay line that is converted into a radiofrequency signal being re-transmitted via an emission antenna and received and analyzed by the interrogator still poses demanding technical problems. Particularly, radiofrequency noise present in the commonly used ISM (Industrial, Scientific, Medical) bands, for example, in bands with a center frequency of 434 MHz or 2.45 GHz, causes reading/interpretation errors affecting the quality of the generation and analysis of response spectra provided by the sensor devices. Therefore, it is an object of the present invention to provide for means for and methods of interrogating an acoustic wave sensor with an increased signal-to-noise ratio as compared to the art.

The present invention addresses the above-mentioned object by providing an interrogation device for interrogating an acoustic wave sensor comprising a transmission antenna configured for transmitting an interrogation radiofrequency signal to the acoustic wave sensor, a reception antenna configured for receiving a response radiofrequency signal from the acoustic wave sensor and a processing means for processing/analyzing the response radiofrequency signal in order to determine an ambient parameter that is to be sensed. The ambient parameter may, for example, be a temperature, a pressure or a strain level of some target sample that is to be monitored.

The processing means (which may comprise a standard CPU, microprocessor or microcontroller, for example) is configured for determining the in-phase components I ($I = Y \cos \varphi$) and the quadrature components Q ($Q = Y \sin \varphi$) of the received response radiofrequency signal in each of N consecutive frames (1st frame, 2nd frame, .., Nth frame) of the response radiofrequency signal, N being an integer larger than 1, wherein each of the N frames comprises X sampling points (a sampling point is a point for which one measures the real and imaginary part of the signal at a given frequency, for example). According to alternative approaches either 1) the moduli (absolute amplitudes) of each pair of the determined in-phase components I and the quadrature components Q are further processed by means of a norm and a weighting function or 2) the determined in-phase components I and the quadrature components Q are further processed by means of an I norm and a Q norm and an I weighting function and a Q weighting function, respectively. It should also be noted that the processing according to both alternatives, in general, can at least partly be carried out in the time domain or the frequency domain.

According to the first alternative, the moduli

[Math. 1]

$$|Y| = \sqrt{I^2 + Q^2}$$

for the X sampling points of each of the N frames are calculated by the processing means. A first norm is calculated based on the calculated moduli. A first weighting function W based on the determined first norm M and the determined moduli |Y| is determined. The in-phase components I and the quadrature components Q of an N+1th frame (for example, directly following the Nth frame) of the received response radiofrequency signal, the N+1th frame comprising X sampling points of the received response radiofrequency signal, are determined. The moduli |Y| of each of the pairs of the determined in-phase components I and the quadrature components Q of the N+1th frame are determined and the first weighting function W is applied to the determined moduli |Y| of the received response radiofrequency signal in the N+1th frame to obtain weighted moduli |Y|w of the received response radiofrequency signal for the N+1th frame. For example, a resonance frequency and, thus, an ambient parameter can be determined based on the weighted moduli.

Thus, according to the first alternative it is provided an interrogation device for interrogating an acoustic wave sensor, comprising a transmission antenna configured for transmitting an interrogation radiofrequency signal to the acoustic wave sensor; a reception antenna configured for receiving a response radiofrequency signal from the acoustic wave sensor; a processing means configured for determining the in-phase components I and the quadrature components Q of the received response radiofrequency signal in each of N consecutive frames of the response radiofrequency signal, N being an integer larger than 1, wherein each of the N frames comprises X sampling points; determining the moduli |Y| of each of the pairs of the determined in-phase components I and the quadrature components Q; determining a first norm M based on the determined moduli |Y|; determining a first weighting function W based on the determined first norm M and the determined moduli |Y|; determining the in-phase components I and the quadrature components Q of an N+1th frame of the received response radiofrequency signal, the N+1th frame comprising X sampling points of the received response radiofrequency signal; determining the moduli |Y| of each of the pairs of the determined in-phase components I and the quadrature components Q of the N+1th frame; and applying the first weighting function W to the determined moduli |Y| of the received response radiofrequency signal in the N+1th frame to obtain weighted moduli |Y|w of the received response radiofrequency signal for the N+1th frame.

According to the second alternative, it is provided an interrogation device for interrogating an acoustic wave sensor, comprising a transmission antenna configured for transmitting an interrogation radiofrequency signal to the acoustic wave sensor; a reception antenna configured for receiving a response radiofrequency signal from the acoustic wave sensor; a processing means configured for determining the in-phase components I and the quadrature components Q of the received response radiofrequency signal in each of N consecutive frames of the response radiofrequency signal, N being an integer larger than 1, wherein each of the N frames comprises X sampling points; determining a first I norm MI based on the determined in-phase components I; determining a first Q norm MQ based on the determined quadrature components Q; determining a first I weighting function WI based on the determined first I norm MI and the determined in-phase components I; determining a first Q weighting function WQ based on the determined first Q norm MQ and the determined quadrature components Q; determining the in-phase components I and the quadrature components Q of an N+1th frame of the received response radiofrequency signal, the N+1th frame comprising X sampling points of the received response radiofrequency signal; applying the first I weighting function WI to the determined in-phase components I of the received response radiofrequency signal in the N+1th frame to obtain weighted in-phase components Iw of the received response radiofrequency signal for the N+1th frame; and applying the first Q weighting function WQ to the determined quadrature components Q of the received response radiofrequency signal in the N+1th frame to obtain weighted quadrature components Qw of the received response radiofrequency signal for the N+1th frame.

From the obtained weighted in-phase components Iw of the received response radiofrequency signal for the N+1th frame and the weighted quadrature components Iw of the received response radiofrequency signal for the N+1th frame weighted moduli can be calculated.

By means of the application of the norm(s) and the weighting function(s) in both alternatives an increased signal-noise ratio as compared to the art can be achieved. This is particularly the case for recursively applying the above-described operations on the following frames wherein for each of the following frames (N+2th frame, N+3th frame, ..) the respective first frame (i.e., the 1st frame when processing the N+2th frame, the 2nd frame (and first frame) when processing the N+3th frame etc.) is neglected when determining the norm(s) and the weighting function(s). Thereby, an efficient adaptive weighting process is provided that takes into account the most recent ambient conditions.

Accordingly, the processing means can be configured (according to first alternative) for determining the in-phase components I and the quadrature components Q of the received response radiofrequency signal in an N+2th frame (for example, directly following the N+1th frame) of the response radiofrequency signal, the N+2th frame comprising X sampling points of the received response radiofrequency signal; determining the moduli |Y| of each of the pairs of the determined in-phase components I and the quadrature components Q of the N+2th frame; determining a second norm M based on the determined moduli |Y| of the 2nd to N+1th frame without using the determined moduli |Y| of the 1st frame of the N frames; determining a second weighting function W based on the determined second norm M and the determined moduli |Y| of the 2nd to N+1th frame without using the determined moduli |Y| of the 1st frame of the N frames; and applying the second weighting function W to the determined moduli |Y| of the received response radiofrequency signal in the N+2th frame to obtain weighted moduli |Y|w of the received response radiofrequency signal for the N+2th frame.

According to the second alternative the processing means can be configured for determining the in-phase components I and the quadrature components Q of the received response radiofrequency signal in an N+2th frame of the response radiofrequency signal, the N+2th frame comprising X sampling points of the received response radiofrequency signal; determining a second I norm MI based on the determined in-phase components I of the 2nd to N+2th frame without using the determined in-phase components I of the 1st frame of the N frames; determining a second Q norm MQ based on the determined quadrature components Q of the 2nd to N+2th frame without using the determined quadrature components Q of the 1st frame of the N frames; determining a second I weighting function WI based on the determined second I norm MI and the determined in-phase components I of the 2nd to N+2th frame without using the determined in-phase components I of the 1st frame of the N frames; determining a second Q weighting function WQ based on the determined second Q norm M and the determined quadrature components Q of the 2nd to N+2th frame without using the determined quadrature components Q of the 1st frame of the N frames; and applying the second Q weighting function WQ to the determined quadrature components Q of the received response radiofrequency signal in the N+2th frame to obtain weighted quadrature components Qw of the received response radiofrequency signal for the N+2th frame.

As already stated these procedures can be carried out recursively for the following N+3th, N+4th, etc. frames.

In the following, concrete non-limiting examples for calculating the norm(s) and weighting function(s) are given for both alternatives. According to the first alternative (calculation of the first norm and first weighting function based on the determined moduli of the N frames) the processing means may be configured to determine the first norm M according to the equation

[Math. 2]

$$M = \sum_{n=1}^{N} \sum_{x=1}^{X} \frac{|Y_n(\omega_x)|}{NX}$$

wherein $|Y_n(\omega_x)|$ denotes the modulus of the in-phase components I and quadrature components Q for the x-th sampling point and the n-th frame. In this case, the processing means may be configured to determine the first weighting function according to the equation

[Math. 3]

$$W(\omega_x) = \sum_{n=1}^{N} Y_n(\omega_n)$$

that includes the average

[Math. 4]

$$\sum_{n=1}^{N} Y_n(\omega_n)$$

of the moduli $Y_n(\omega_n)$ over the N frames for each sampling point x (x= 1, .., X).

The processing means may be further configured for applying a Gaussian density function to the obtained weighted moduli |Y|w in order to even further increase the signal-to-noise ratio.

According to the second alternative (the determined in-phase components I and the quadrature components Q are further processed by means of an I norm and a Q norm and an I weighting function and a Q weighting function, respectively) the processing means may be configured to determine the first I norm MI according to the equation

[Math. 5]

$$M^I = \sum_{n=1}^{N} \sum_{x=1}^{X} \frac{I_n(\omega_x)}{NX}$$

wherein In($\omega$x) denotes the in-phase component for the x-th sampling point and the n-th frame and to determine the first Q norm MQ according to the equation

[Math. 6]

$$M^Q = \sum_{n=1}^{N} \sum_{x=1}^{X} \frac{Q_n(\omega_x)}{NX}$$

wherein Qn($\omega$x) denotes the quadrature component for the x-th sampling point and the n-th frame.

In this case, the processing means may be configured to determine the first I weighting function WI according to the equation

[Math. 7]

$$W^I(\omega_x) = \sum_{n=1}^{N} \frac{I_n(\omega_n)}{NM}$$

and the first Q weighting function WQ according to the equation

[Math. 8]

$$W^Q(\omega_x) = \sum_{n=1}^{N} \frac{Q_n(\omega_n)}{NM}$$

As in the first alternative the signal-to-noise ratio may be further enhanced by application of a Gaussian density function. Thus, the processing means may be further configured for calculating weighted moduli |Y|w for the obtained weighted in-phase components Iw of the received response radiofrequency signal for the N+1th frame and the obtained weighted quadrature components Qw of the received response radiofrequency signal for the N+1th frame and applying a Gaussian density function to the calculated weighted moduli |Y|w. As in the first alternative the Gaussian density function can be applied to the following frames N+2, N+3, etc. within the recursive procedure described above.

The efficiency and reliability of the operation of the above-described embodiments can be further increased by neglecting defective frames. Thus, the interrogation device according to any of the above-described embodiments may further comprise a filtering means (that might be part of the processing means) that is configured for filtering the received response radiofrequency signal before determining either the first norm M or first I norm MI and first Q norm MQ in order to eliminate such frames of the N frames that show variances or standard deviations in the in-phase components I and the quadrature components Q over the respective entire frame that exceed a predetermined variance threshold or standard deviation threshold. It is to be understood that when the optional filtering in order to eliminate defective frames is performed the N frames, N+1th and N+2th frame mentioned above represent non-defective and the corresponding following non-defective frames, respectively.

The variance or standard deviations thresholding, according to an embodiment, can be realized as follows. The variance or standard deviations of the in-phase components I and the quadrature components Q over a particular entire frame of the N frames, for example, the 1st frame, is calculated and represent an initial threshold. For the following frames, again, the variances or standard deviations of the in-phase components I and the quadrature components Q over the respective entire frames are calculated. If the variances or standard deviations for the following frames are decreasing, the threshold value will be updated by the variances or standard deviations of the following frames. When a variance or standard deviation of a following frame is larger than the one of the previous frame the variance or standard deviation of the previous frame is used as the threshold value.

Furthermore, it is provided a system for monitoring/measuring an ambient parameter, for example, a temperature, a strain level, a pressure or a torque level of a rotating axis, that comprises an interrogation device according to one of the above-described embodiments and an acoustic wave sensor device communicatively coupled to the interrogation device, wherein the acoustic wave sensor device, for example, is a passive surface acoustic wave sensor device.

Moreover, methods of interrogating an acoustic wave sensor wherein the above described processing steps are performed are provided herein. Additionally, a computer program product comprising instructions causing a processing means (when run on the processing means) to perform the above described processing steps are performed is provided herein.

As already stated processing can at least partly be performed in the time or the frequency domain. All of the above-cited equations can directly be translated to the corresponding expression in the frequency domain and it is to be understood that the adequate representations of norms and weighting functions in the time domain are covered by the claimed invention.

Additional features and advantages of the present invention will be described with reference to the drawings. In the description, reference is made to the accompanying figures that are meant to illustrate preferred embodiments of the invention. It is understood that such embodiments do not represent the full scope of the invention.

[Fig. 1] represent a system comprising an acoustic wave sensor and an interrogation device wherein the present invention according to an embodiment can be implemented.

[Fig. 2] represent a flow diagram illustrating the processing of a received response radiofrequency signal according to an embodiment of the present invention.

[Fig. 3] represent the effect of the processing of a received response radiofrequency signal according to an embodiment of the present invention on the signal quality of the obtained signal.

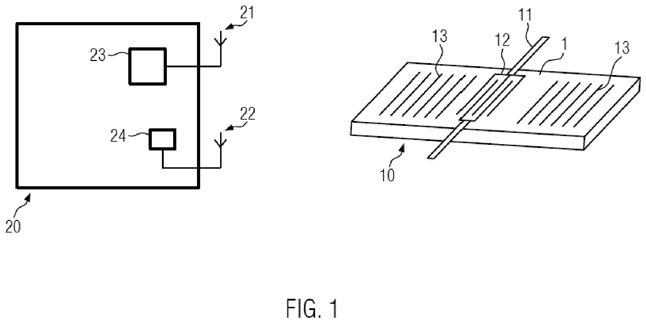

The present invention provides techniques for the remote interrogation of passive acoustic wave sensors, in particular, SAW sensors, wherein the techniques are characterized by a high signal-to-noise ratio. The techniques can be applied to any interrogators that are configured to determine a response spectrum from an interrogated acoustic wave sensor. The interrogated acoustic wave sensor can, for example, be a resonator device, for example, a differential SAW sensor. Figure 1 illustrates an exemplary relative simple system (i.e. a resonator exhibiting several modes that satisfy the cavity resonance conditions) wherein the invention according to an embodiment can be implemented. It goes without saying that the invention can be implemented in any devices employing acoustic wave sensors or dielectric resonators, RLC circuits, etc. Interrogation devices used can include any reader operating with an IQ-detector in a network analyzer signal acquisition/processing mode, for example.

The system shown in Figure 1 comprises a resonator 1, an acoustic wave (SAW) sensor device 10 comprising an antenna 11 for receiving an interrogation radiofrequency signal and transmitting a response radiofrequency signal, a comb transducer 12 connected to the antenna 11 and comprising interdigitated electrodes and a SAW resonance cavity 13 comprising two series of reflectors. The sensor device 10 may comprise a SAW-based sensor built on single-crystal piezoelectric materials like quartz (SiO2), lithium niobate (LiNbO3), lithium tantalate (LiTaO3), langasite (LGS) or poly-crys-tal piezoelectric materials like aluminum nitride (AIN) or zinc oxide (ZnO), in particular, deposited on silicon, or even on a Piezo-On-Insulator (POI) composite material comprising a layer of piezoelectric material, in particular, a single-crystal material, such as, for example, lithium tantalate or lithium niobate, bonded to a support substrate as for instance silicon, if necessary by means of a bonding layer, as for instance a silicon oxide layer. The transducer 12 converts the interrogation radiofrequency signal received by the antenna 11 into an acoustic wave that is reflected back by the reflectors of the resonance cavity 13 and converted back into a radiofrequency signal that in course is transmitted by the antenna 11 as a response radiofrequency signal.

The system furthermore comprises an interrogation device 20 comprising a transmission antenna 21 for transmitting an interrogation radiofrequency signal to the acoustic wave (SAW) sensor device 10 and a reception antenna 22 for receiving a response radiofrequency signal from the acoustic wave (SAW) sensor device 10. The interrogation radiofrequency signal transmitted by the transmission antenna 21 is generated by a signal generator 23 that may comprise a radiofrequency synthesizer or oscillator as well as optionally some signal shaping module providing a suitable frequency transposition and/or amplification of the signal to be transmitted by the transmission antenna 21. The interrogation radiofrequency signal generated by the signal generator 23 may be a pulsed or bursty signal with a frequency selected according to the resonance frequency of the acoustic sensor device 10.

Furthermore, the interrogation device 20 comprises a processing means 24 connected to the reception antenna 22. The processing means 24 may comprise filtering and/or amplification means and be configured for analysing the response radiofrequency signal received by the reception antenna 22. For example, the sensor device 10 operates at a resonance frequency of 434 MHz or 2.45 GHz. The interrogation device 20 may transmit a long radiofrequency pulse and after the transmission has been stopped, the resonance cavity 13 discharges at its resonant eigenfrequency with a time constant $\tau$ equal to $Qf/\pi F$ wherein F is the central frequency and Qf is the quality factor Qf corresponding to the ratio between the central frequency and the width at half maximum of the band pass used in the interrogation process. Spectral analysis performed by the processing means 24 of the interrogation device 20 allows for calculating the resonator frequency and, thereby, the sensing of an ambient parameter. The received response radiofrequency signal may be mixed by the processing means with interrogation radiofrequency signal according to the so-called I-Q protocol as known in the art to extract the real and imaginary parts (in-phase I and quadrature Q) from which the modulus and phase can then be derived.

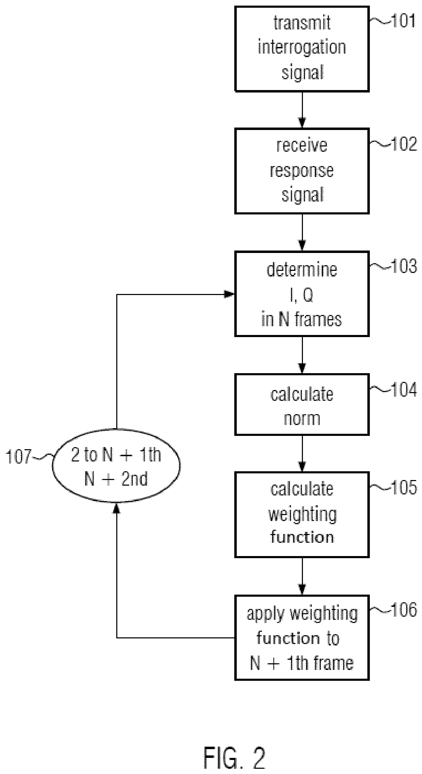

According to the invention, processing of the received response radiofrequency signal by means of a norm and a weighting function is performed in order to increase the signal-to-noise ratio. The processing can, in principle, be performed at least partly in the time domain or the frequency (spectral) domain. For exemplary purposes, in the following processing in the spectral domain will be considered. Figure 2 shows a flow diagram illustrating the processing according to an embodiment of the present invention, for example, a kind of processing that can be performed by the processing means 24 of the interrogation device 20 shown in Figure 1.

At a first step in the procedure an interrogation radiofrequency signal is transmitted 101 by an interrogation device, for example, the interrogation device 20 shown in Figure 1, to an acoustic wave sensor device, for example, the acoustic sensor device 10 shown in Figure 1. The interrogation device receives a response radiofrequency signal 102. The received response radiofrequency signal is processed/analysed by the interrogation device, for example, the processing means 24 of the interrogation device 20 shown in Figure 1.

In particular, the in-phase components I and the quadrature components Q of the received response radiofrequency signal in each of N consecutive frames (1, .., N) of the response radiofrequency signal, N being an integer larger than 1, wherein each of the N frames comprises X sampling (frequency) points, are determined 103, for example by employing an I-Q protocol. For example, X may lie in a range of 100 to 1000 and N may lie in a range of 20 to 100.

Based on the determined in-phase components I and the quadrature components Q a norm is determined 104. According to a particular embodiment, the moduli

[Math. 9]

$$|Y| = \sqrt{I^2 + Q^2}$$

for the pairs of the determined in-phase components I and the quadrature components Q of the N frames of the received response radiofrequency signal are calculated. A first norm is calculated 104 according to the equation

[Math. 10]

$$M = \sum_{n=1}^{N} \sum_{x=1}^{X} \frac{|Y_n(\omega_x)|}{NX}$$

wherein $|Y_n(\omega_x)|$ denotes the modulus of the in-phase components I and quadrature components Q for the x-th sampling point and the n-th frame.

Based on the first norm a first weighting function

[Math. 11]

$$W(\omega_x) = \sum_{n=1}^{N} Y_n(\omega_n)$$

is calculated 105. This weighting function is applied 106 to an N+1th frame (also comprising X sampling points) of the received response radiofrequency signal that may follow directly the Nth frame (for the matter of understanding function means that there is not a unique or single value that is applied to the data series of the N+1th frame but that the weighting depends on the recorded signals at each sampling point, the weigthing operation thereby achieved by multiplication of the weighting at each sampling point with the value of that sampling point in the N+1th frame). The in-phase components I and the quadrature components Q of the N+1th frame of the received response radiofrequency signal are determined and the moduli |Y| of each of the pairs of the determined in-phase components I and the quadrature components Q of the N+1th frame are determined. The weighting function is applied to the moduli in order to obtain weighted moduli showing a superior signal-to-noise ratio. From the weighted moduli a resonance frequency may be determined by fitting the data to an appropriate fitting function, in particular a Gaussian fitting as described in more detail below, and based on the determined resonance frequency an ambient parameter can be monitored.

The above-described procedure according to this embodiment is recursively carried out for the following frames N+2, N+3, etc. wherein in each of the recursive loops the norm (and, thus, the weighting function) is calculated neglecting the first frame used in the previous loop. So, in the next loop 107, the first (oldest) frame 1 is excised from consideration and a second (updated) norm is calculated by using the 2nd to N+1th frames:

[Math. 12]

$$M = \sum_{n=2}^{N+1} \sum_{x=1}^{X} \frac{|Y_n(\omega_x)|}{NX}$$

Accordingly, in the next loop 107 the (second) weighting function is given by

[Math. 13]

$$W(\omega_x) = \sum_{n=2}^{N+1} Y_n(\omega_n)$$

and it is to be applied to the N+2th frame, etc.

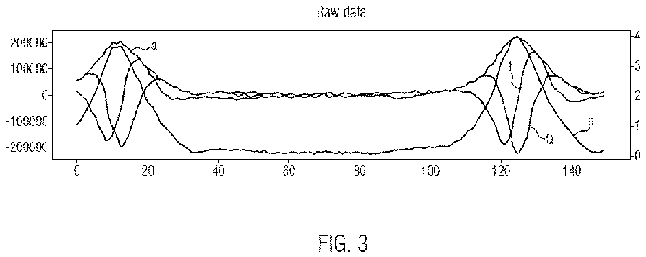

Figure 3 illustrates the effect of such a kind of processing with respect to an enhanced signal-to-noise ratio. Figure 3 shows raw data of the I and Q components and the modulus (graph a) obtained for the raw data. In comparison, graph b in Figure 3 shows the obtained weighted modulus obtained by the above-described procedure. As it becomes obvious from Figure 3 the signal-of-noise ratio can be increased by one order of magnitude in this example.

Whereas in the above-described embodiment a norm and a weighting function are determined and applied on moduli of the I and Q components, alternatively, norms and weighting functions can be determined for the I and Q components, separately, and the thus obtained weighting functions can be applied to the I and Q components of the respective following frame. According to this alternative, a first I norm MI according to the equation

[Math. 14]

$$M^I = \sum_{n=1}^{N} \sum_{x=1}^{X} \frac{I_n(\omega_x)}{NX}$$

is calculated wherein In($\omega$x) denotes the in-phase component for the x-th sampling point and the n-th frame and a first Q norm MQ is calculated according to the equation

[Math. 15]

$$M^Q = \sum_{n=1}^{N} \sum_{x=1}^{X} \frac{Q_n(\omega_x)}{NX}$$

wherein Qn($\omega$x) denotes the quadrature component for the x-th sampling point and the n-th frame.

Accordingly, a first I weighting function WI is calculated according to the equation

[Math. 16]

$$W^I(\omega_x) = \sum_{n=1}^{N} \frac{I_n(\omega_n)}{NM^I}$$

and a first Q weighting function WQ is calculated according to the equation

[Math. 17]

$$W^Q(\omega_x) = \sum_{n=1}^{N} \frac{Q_n(\omega_n)}{NM^Q}$$

The first I weighting function WI is then applied to the I components of the N+1th frame and the first Q weighting function WQ is applied to the Q components of the N+1th frame. Correspondingly, a second I norm MI and a second Q norm MQ are calculated

[Math. 18]

$$M^I = \sum_{n=2}^{N+1} \sum_{x=1}^{X} \frac{I_n(\omega_x)}{NX} \;\; ; \;\; M^Q = \sum_{n=2}^{N+1} \sum_{x=1}^{X} \frac{Q_n(\omega_x)}{NX}$$

in order to determine a second I weighting function WI as well as a second Q weighting function WQ

[Math. 19]

$$W^I(\omega_x) = \sum_{n=2}^{N+1} \frac{I_n(\omega_n)}{NM^I} \;\; ; \;\; W^Q(\omega_x) = \sum_{n=2}^{N+1} \frac{Q_n(\omega_n)}{NM^Q}$$

that are to be applied to the I and Q components, respectively, of the N+1th frame, in order to obtain weighted I and Q components. Weighted moduli can be readily calculated from the weighted I and Q components. Further recursive loops (for the N+2th frame, N+3th frame etc.) follow in a straightforward manner (each loop neglecting the respective first frame of the previous loop).

According to particular embodiments step 104 of the flow diagram of Figure 2 is preceded by a step of pre-filtering in order to eliminate defective frames. In fact, frames of the N frames that show a variance in the in-phase components I and the quadrature components Q over the respective entire frame that exceed a predetermined variance threshold can be eliminated. The thresholding can be adaptive. For example, the variance threshold may be dynamically determined by setting an initial threshold as the variance of the in-phase components I and the quadrature components Q in a particular one of the N frames and determining the threshold as the variance of the in-phase components I and the quadrature components Q in a frame directly following the particular frame if it is smaller than the variance in the particular frame or, else, maintaining the initial threshold. This process can be recursively performed for the following frames, i.e., for the following frames, again, the variances of the in-phase components I and the quadrature components Q over the respective entire frames are calculated and, if the variances for the following frames are decreasing, the threshold value will be updated by the variances of the following frames. When a variance of a following frame is larger than the one of the previous frame the variance of the previous frame is used as the threshold value.

Furthermore, a Gaussian density function ~ exp(-0,5 (|b-x|/c)2), with x denoting the time or frequency variable, c denoting the variance and b denoting the maximum of x, can be applied to the resulting weighted moduli in both alternative approaches described above. Thereby, the resonance frequency of a resonator device as the one illustrated in Figure 1 can be reliably extracted, for example. Fitting the processed signal with such a density function yields direct access to the resonance frequency corresponding to the variable b.

Any smoothing of data in the context of some post-processing as needed in the art is no longer necessary due to the obtained high signal-to-noise ratio. Particularly, any signal components exhibiting amplitudes close to the noise level can reliably be minimized or even eliminated.

By means of the herein disclosed techniques an ambient parameter can be sensed using an acoustic wave sensor device and an interrogation device interrogating the acoustic wave sensor wherein by employing a norm and a weighting function an enhanced signal-to-noise ratio can be achieved. Particularly, the stability of the measurement of an ambient parameter as, for example, a temperature, strain, pressure or torque of a rotating axis, allows for a robust and reliable monitoring.

All previously discussed embodiments are not intended as limitations but serve as examples illustrating features and advantages of the invention. It is to be understood that some or all of the above described features can also be combined in different ways as long as the combination remains within the scope of the appended claims.

**Claims**

1. An interrogation device (20) for interrogating an acoustic wave sensor (10), comprising

   a transmission antenna (21) configured for transmitting (101) an interrogation radiofrequency signal to the acoustic wave sensor (10);
   a reception antenna (22) configured for receiving a response radiofrequency (102) signal from the acoustic wave sensor (10); and
   a processing means (24) configured for
   determining (103) the in-phase components I and the quadrature components Q of the received response radiofrequency signal (102) in each of N consecutive frames of the response radiofrequency signal (102), N being an integer larger than 1, wherein each of the N frames comprises X sampling points;
   determining the moduli |Y| of each of the pairs of the determined in-phase components I and the quadrature components Q;
   determining (104) a first norm M based on the determined moduli |Y|;
   determining (105) a first weighting function W based on the determined first norm M and the determined moduli |Y|;
   determining the in-phase components I and the quadrature components Q of an N+1th frame of the received response radiofrequency signal, the N+1th frame comprising X sampling points of the received response radiofrequency signal (102);
   determining the moduli |Y| of each of the pairs of the determined in-phase components I and the quadrature components Q of the N+1th frame; and **characterised by** applying (106) the first weighting function W to the determined moduli |Y| of the received response radiofrequency signal (102) in the N+1th frame to obtain weighted moduli |Y|w of the received response radiofrequency signal (102) for the N+1th frame.

2. An interrogation device (20) for interrogating an acoustic wave sensor (10), comprising

   a transmission antenna (22) configured for transmitting (101) an interrogation radiofrequency signal to the acoustic wave sensor (10);
   a reception antenna (21) configured for receiving a response radiofrequency signal (102) from the acoustic wave sensor (10); and
   a processing means (24) configured for
   determining (103) the in-phase components I and the quadrature components Q of the received response radiofrequency signal (102) in each of N consecutive frames of the response radiofrequency signal (102), N being an integer larger than 1, wherein each of the N frames comprises X sampling points;
   determining a first I norm MI based on the determined in-phase components I;
   determining a first Q norm MQ based on the determined quadrature components Q;
   determining a first I weighting function WI based on the determined first I norm MI and the determined in-phase components I;
   determining a first Q weighting function WQ based on the determined first Q norm MQ and the determined quadrature components Q;
   determining the in-phase components I and the quadrature components Q of an N+1th frame of the received response radiofrequency signal (102), the N+1th frame comprising X sampling points of the received response radiofrequency signal (102);
   applying the first I weighting function WI to the determined in-phase components I of the received response radiofrequency signal (102) in the N+1th frame to obtain weighted in-phase components Iw of the received response radiofrequency signal (102) for the N+1th frame; and **characterised by**
   applying the first Q weighting function WQ to the determined quadrature components Q of the received response radiofrequency signal (102) in the N+1th frame to obtain weighted quadrature components Qw of the received response radiofrequency signal (102) for the N+1th frame.

3. The interrogation device (20) according to claim 1, wherein the processing means (24) is further configured for

   determining the in-phase components I and the quadrature components Q of the received response radiofrequency signal in an N+2th frame of the response radiofrequency signal (102), the N+2th frame comprising X sampling points of the received response radiofrequency signal (102);
   determining the moduli |Y| of each of the pairs of the determined in-phase components I and the quadrature components Q of the N+2th frame;

determining a second norm M based on the determined moduli |Y| of the 2nd to N+1th frame without using the determined moduli |Y| of the 1st frame of the N frames;

determining a second weighting function W based on the determined second norm M and the determined moduli |Y| of the 2nd to N+1th frame without using the determined moduli |Y| of the 1st frame of the N frames; and

applying the second weighting function W to the determined moduli |Y| of the received response radiofrequency signal (102) in the N+2th frame to obtain weighted moduli |Y|w of the received response radiofrequency signal (102) for the N+2th frame.

4. The interrogation device (20) according to claim 2, wherein the processing means (24) is further configured for

determining the in-phase components I and the quadrature components Q of the received response radiofrequency signal (102) in an N+2th frame of the response radiofrequency signal (102), the N+2th frame comprising X sampling points of the received response radiofrequency signal;

determining a second I norm MI based on the determined in-phase components I of the 2nd to N+2th frame without using the determined in-phase components I of the 1st frame of the N frames;

determining a second Q norm MQ based on the determined quadrature components Q of the 2nd to N+2th frame without using the determined quadrature components Q of the 1st frame of the N frames;

determining a second I weighting function WI based on the determined second I norm MI and the determined in-phase components I of the 2nd to N+2th frame without using the determined in-phase components I of the 1st frame of the N frames;

determining a second Q weighting function WQ based on the determined second Q norm M and the determined quadrature components Q of the 2nd to N+2th frame without using the determined quadrature components Q of the 1st frame of the N frames;

applying the second I weighting function WI to the determined in-phase components I of the received response radiofrequency signal (102) in the N+2th frame to obtain weighted in-phase components Iw of the received response radiofrequency signal (102) for the N+2th frame; and

applying the second Q weighting function WQ to the determined quadrature components Q of the received response radiofrequency signal (102) in the N+2th frame to obtain weighted quadrature components Qw of the received response radiofrequency signal (102) for the N+2th frame.

5. The interrogation device (20) according to claim 1 or 3, wherein the processing means (24) is configured to determine (104) the first norm M according to the equation

$$M = \sum_{n=1}^{N} \sum_{x=1}^{X} \frac{|Y_n(\omega_x)|}{NX}$$

wherein $|Y_n(\omega_x)|$ denotes the modulus of the in-phase components I and quadrature components Q for the x-th sampling point and the n-th frame.

6. The interrogation device (20) according to claim 5, wherein the processing means (24) is configured to determine (105) the first weighting function according to the equation

$$W(\omega_x) = \sum_{n=1}^{N} Y_n(\omega_n)$$

7. The interrogation device (20) according to one of the claims 1, 3, 5 and 6, wherein the processing means (24) is further configured for applying a Gaussian density function to the obtained weighted moduli |Y|w.

8. The interrogation device (20) according to claim 2 or 4, wherein the processing means (24) is configured to determine (104) the first I norm MI according to the equation

$$M^I = \sum_{n=1}^{N} \sum_{x=1}^{X} \frac{I_n(\omega_x)}{NX}$$

wherein In(ωx) denotes the in-phase component for the x-th sampling point and the n-th frame and to determine the first Q norm MQ according to the equation

$$M^Q = \sum_{n=1}^{N} \sum_{x=1}^{X} \frac{Q_n(\omega_x)}{NX}$$

wherein Qn(ωx) denotes the quadrature component for the x-th sampling point and the n-th frame.

9. The interrogation device (20) according to claim 8, wherein the processing means (24) is configured to determine the first I weighting function WI according to the equation

$$W^I(\omega_x) = \sum_{n=1}^{N} \frac{I_n(\omega_n)}{NM^I}$$

and the first Q weighting function WQ according to the equation

$$W^Q(\omega_x) = \sum_{n=1}^{N} \frac{Q_n(\omega_n)}{NM^Q}$$

10. The interrogation device (20) according to one of the claims 2, 4, 8 and 9, wherein the processing means (24) is further configured for
calculating weighted moduli |Y|w for the obtained weighted in-phase components Iw of the received response radiofrequency signal (102) for the N+1th frame and the obtained weighted quadrature components Qw of the received response radiofrequency signal (102) for the N+1th frame and applying a Gaussian density function to the calculated weighted moduli |Y|w.

11. The interrogation device (20) according to one of the preceding claims, further comprising filtering means configured for filtering the received response radiofrequency signal (102) before determining either the first norm M or the first I norm MI and first Q norm MQ in order to eliminate such frames of the N frames that show variances or standard deviations in the in-phase components I and the quadrature components Q over the respective entire frame that exceed a predetermined variance or standard deviation threshold.

12. The interrogation device (20) according to claim 11, wherein the filtering means is configured to dynamically determine the variance or standard deviations or the corresponding threshold by determining an initial threshold as the variance or standard deviation of the in-phase components I and the quadrature components Q in a particular one of the N frames and determining the threshold as the variance or standard deviations of the in-phase components I and the quadrature components Q in a frame directly following the particular frame if it is smaller than the variance or standard deviation in the particular frame.

13. System for monitoring an ambient parameter, comprising

an interrogation device (20) according to one of the preceding claims; and
an acoustic wave sensor device (10) communicatively coupled to the interrogation device, wherein the acoustic wave sensor device (10), in particular, is a passive surface acoustic wave sensor device and the ambient parameter, in particular, is a temperature, strain, pressure or torque of a rotating axis.

**Patentansprüche**

1. Abfragevorrichtung (20) für das Abfragen eines Schallwellensensors (10), umfassend:

   eine Sendeantenne (21), die konfiguriert ist zum Senden (101) eines Hochfrequenz-Abfragesignals zu dem Schallwellensensor (10),
   eine Empfangsantenne (22), die konfiguriert ist zum Empfangen eines Hochfrequenz-Antwortsignals (102) von dem Schallwellensensor (10), und
   eine Verarbeitungseinrichtung (24), die konfiguriert ist zum:

   Bestimmen (103) der In-Phase-Komponenten I und der Quadraturkomponenten Q des empfangenen Hochfrequenz-Antwortsignals (102) in jedem von N aufeinanderfolgenden Rahmen des Hochfrequenz-Antwortsignals (102), wobei N eine Ganzzahl größer als 1 ist und wobei jeder der N Rahmen X Abtastungspunkte umfasst,
   Bestimmen der Moduli |Y| jedes der Paare der bestimmten In-Phase-Komponenten I und der Quadraturkomponenten Q,
   Bestimmen (104) einer ersten Norm M basierend auf den bestimmten Moduli |Y|,
   Bestimmen (105) einer ersten Gewichtungsfunktion W basierend auf der bestimmten ersten Norm M und den bestimmten Moduli |Y|,
   Bestimmen der In-Phase-Komponenten I und der Quadraturkomponenten Q eines N+1-ten Rahmens des empfangenen Hochfrequenz-Antwortsignals, wobei der N+1-te Rahmen X Abtastungspunkte des empfangenen Hochfrequenz-Antwortsignals (102) umfasst, und
   Bestimmen der Moduli |Y| jedes der Paare der bestimmten In-Phase-Komponenten I und der Quadraturkomponenten Q des N+1-ten Rahmens,
   **gekennzeichnet durch**:
   Anwenden (106) der ersten Gewichtungsfunktion W auf die bestimmten Moduli |Y| des empfangenen Hochfrequenz-Antwortsignals (102) in dem N+1-ten Rahmen, um gewichtete Moduli |Y|w des empfangenen Hochfrequenz-Antwortsignals (102) für den N+1-ten Rahmen zu erhalten.

2. Abfragevorrichtung (20) für das Abfragen eines Schallwellensensors (10), umfassend:

   eine Sendeantenne (22), die konfiguriert ist zum Senden (101) eines Hochfrequenz-Abfragesignals zu dem Schallwellensensor (10),
   eine Empfangsantenne (21), die konfiguriert ist zum Empfangen eines Hochfrequenz-Antwortsignals (102) von dem Schallwellensensor (10), und
   eine Verarbeitungseinrichtung (24), die konfiguriert ist zum:

   Bestimmen (103) der In-Phase-Komponenten I und der Quadraturkomponenten Q des empfangenen Hochfrequenz-Antwortsignals (102) in jedem von N aufeinanderfolgenden Rahmen des Hochfrequenz-Antwortsignals (102), wobei N eine Ganzzahl größer als 1 ist und wobei jeder der N Rahmen X Abtastungspunkte umfasst,
   Bestimmen einer ersten I-Norm MI basierend auf den bestimmten In-Phase-Komponenten I,
   Bestimmen einer ersten Q-Norm MQ basierend auf den bestimmten Quadraturkomponenten Q,
   Bestimmen einer ersten I-Gewichtungsfunktion WI basierend auf der bestimmten ersten I-Norm MI und den bestimmten In-Phase-Komponenten I,
   Bestimmen einer ersten Q-Gewichtungsfunktion WQ basierend auf der bestimmten ersten Q-Norm MQ und den bestimmten Quadraturkomponenten Q,
   Bestimmen der In-Phase-Komponenten I und der Quadraturkomponenten Q eines N+1-ten Rahmens des empfangenen Hochfrequenz-Antwortsignals (102), wobei der N+1-te Rahmen X Abtastungspunkte des empfangenen Hochfrequenz-Antwortsignals (102) umfasst,
   Anwenden der ersten I-Gewichtungsfunktion WI auf die bestimmten In-Phase-Komponenten I des empfangenen Hochfrequenz-Antwortsignals (102) in dem N+1-ten Rahmen, um gewichtete In-Phase-Komponenten Iw des empfangenen Hochfrequenz-Antwortsignals (102) für den N+1-ten Rahmen zu erhalten,
   **gekennzeichnet durch**:
   Anwenden der ersten Q-Gewichtungsfunktion WQ auf die bestimmten Quadraturkomponenten Q des empfangenen Hochfrequenz-Antwortsignals (102) in dem N+1-ten Rahmen, um gewichtete Quadraturkomponenten Qw des empfangenen Hochfrequenz-Antwortsignals (102) für den N+1-ten Rahmen zu erhalten.

3. Abfragevorrichtung (20) nach Anspruch 1, wobei die Verarbeitungseinrichtung (24) weiterhin konfiguriert ist zum:

Bestimmen der In-Phase-Komponenten I und der Quadraturkomponenten Q des empfangenen Hochfrequenz-Antwortsignals in einem N+2-ten Rahmen des Hochfrequenz-Antwortsignals (102), wobei der N+2-te Rahmen X Abtastungspunkte des empfangenen Hochfrequenz-Antwortsignals (102) umfasst,
Bestimmen der Moduli |Y| jedes der Paare der bestimmten In-Phase-Komponenten I und der Quadraturkomponenten Q des N+2-ten Rahmens,
Bestimmen einer zweiten Norm M basierend auf den bestimmten Moduli |Y| des zweiten bis N+1-ten Rahmens ohne eine Verwendung der bestimmten Moduli |Y| des ersten Rahmens der N Rahmen,
Bestimmen einer zweiten Gewichtungsfunktion W basierend auf der bestimmten zweiten Norm M und den bestimmten Moduli |Y| des zweiten bis N+1-ten Rahmens ohne eine Verwendung der bestimmten Moduli |Y| des ersten Rahmens der N Rahmen, und
Anwenden der zweiten Gewichtungsfunktion W auf die bestimmten Moduli |Y| des empfangenen Hochfrequenz-Antwortsignals (102) in dem N+2-ten Rahmen, um gewichtete Moduli |Y|w des empfangenen Hochfrequenz-Antwortsignals (102) für den N+2-ten Rahmen zu erhalten.

4. Abfragevorrichtung (20) nach Anspruch 2, wobei die Verarbeitungseinrichtung (24) weiterhin konfiguriert ist zum:

Bestimmen der In-Phase-Komponenten I und der Quadraturkomponenten Q des empfangenen Hochfrequenz-Antwortsignals (102) in einem N+2-ten Rahmen des Hochfrequenz-Antwortsignals (102), wobei der N+2-te Rahmen X Abtastungspunkte des empfangenen Hochfrequenz-Antwortsignals umfasst,
Bestimmen einer zweiten I-Norm MI basierend auf den bestimmten In-Phase-Komponenten I des zweiten bis N+2-ten Rahmens ohne eine Verwendung der bestimmten In-Phase-Komponenten I des ersten Rahmens der N Rahmen,
Bestimmen einer zweiten Q-Norm MQ basierend auf den bestimmten Quadraturkomponenten Q des zweiten bis N+2-ten Rahmens ohne eine Verwendung der bestimmten Quadraturkomponenten Q des ersten Rahmens der N Rahmen,
Bestimmen einer zweiten I-Gewichtungsfunktion WI basierend auf der bestimmten zweiten I-Norm MI und den bestimmten In-Phase-Komponenten I des zweiten bis N+2-ten Rahmens ohne eine Verwendung der bestimmten In-Phase-Komponenten I des ersten Rahmens der N Rahmen.
Bestimmen einer zweiten Q-Gewichtungsfunktion WQ basierend auf der bestimmten zweiten Q-Norm M und den bestimmten Quadraturkomponenten Q des zweiten bis N+2-ten Rahmens ohne eine Verwendung der bestimmten Quadraturkomponenten Q des ersten Rahmens der N Rahmen,
Anwenden der zweiten I-Gewichtungsfunktion WI der bestimmten In-Phase-Komponenten I des empfangenen Hochfrequenz-Antwortsignals (102) in dem N+2-ten Rahmen, um gewichtete In-Phase-Komponenten Iw des empfangenen Hochfrequenz-Antwortsignals (102) für den N+2-ten Rahmen zu erhalten, und
Anwenden der zweiten Q-Gewichtungsfunktion WQ auf die bestimmten Quadraturkomponenten Q des empfangenen Hochfrequenz-Antwortsignals (102) in dem N+2-ten Rahmen, um gewichtete Quadraturkomponenten Qw des empfangenen Hochfrequenz-Antwortsignals (102) für den N+2-ten Rahmen zu erhalten.

5. Abfragevorrichtung (20) nach Anspruch 1 oder 3, wobei die Verarbeitungseinrichtung (24) konfiguriert ist zum Bestimmen (104) der ersten Norm M gemäß der Gleichung

$$M = \sum_{n=1}^{N} \sum_{x=1}^{X} \frac{|Y_n(\omega_x)|}{NX}$$

wobei |Yn(ωx)| den Modulus der In-Phase-Komponenten I und der Quadraturkomponenten Q für den x-ten Abtastungspunkt und den n-ten Rahmen angibt.

6. Abfragevorrichtung (20) nach Anspruch 5, wobei die Verarbeitungseinrichtung (24) konfiguriert ist zum Bestimmen (105) der ersten Gewichtungsfunktion gemäß der Gleichung

$$W(\omega_x) = \sum_{n=1}^{N} Y_n(\omega_n)$$

7.  Abfragevorrichtung (20) nach einem der Ansprüche 1, 3, 5 und 6, wobei die Verarbeitungseinrichtung (24) weiterhin konfiguriert ist zum Anwenden einer Gaußschen Dichtefunktion auf die erhaltenen gewichteten Moduli |Y|w.

8.  Abfragevorrichtung (20) nach Anspruch 2 oder 4, wobei die Verarbeitungseinrichtung (24) konfiguriert ist zum Bestimmen (104) der ersten I-Norm MI gemäß der Gleichung

$$M^I = \sum_{n=1}^{N} \sum_{x=1}^{X} \frac{I_n(\omega_x)}{NX}$$

wobei In(ωx) die In-Phase-Komponente für den x-ten Abtastungspunkt und den n-ten Rahmen wiedergibt, und zum Bestimmen der ersten Q-Norm MQ gemäß der Gleichung

$$M^Q = \sum_{n=1}^{N} \sum_{x=1}^{X} \frac{Q_n(\omega_x)}{NX}$$

wobei Qn(ωx) die Quadraturkomponente für den x-ten Abtastungspunkt und den n-ten Rahmen wiedergibt.

9.  Abfragevorrichtung (20) nach Anspruch 8, wobei die Verarbeitungseinrichtung (24) konfiguriert ist zum Bestimmen der ersten I-Gewichtungsfunktion WI gemäß der Gleichung

$$W^I(\omega_x) = \sum_{n=1}^{N} \frac{I_n(\omega_n)}{NM^I}$$

und der ersten Q-Gewichtungsfunktion WQ gemäß der Gleichung

$$W^Q(\omega_x) = \sum_{n=1}^{N} \frac{Q_n(\omega_n)}{NM^Q}$$

10. Abfragevorrichtung (20) nach einem der Ansprüche 2, 4, 8 und 9, wobei die Verarbeitungseinrichtung (24) weiterhin konfiguriert ist zum:
    Berechnen von gewichteten Moduli |Y|w für die erhaltenen gewichteten In-Phase-Komponenten Iw des empfangenen Hochfrequenz-Antwortsignals (102) für den N+1-ten Rahmen und die erhaltenen gewichteten Quadraturkomponenten Qw des empfangenen Hochfrequenz-Antwortsignals (102) für den N+1-ten Rahmen, und Anwenden einer Gaußschen Dichtefunktion auf die berechneten gewichteten Moduli |Y|w.

11. Abfragevorrichtung (20) nach einem der vorstehenden Ansprüche, die weiterhin eine Filtereinrichtung umfasst, die konfiguriert ist zum Filtern des empfangenen Hochfrequenz-Antwortsignals (102) vor dem Bestimmen entweder der ersten Norm M oder der ersten I-Norm MI und der ersten Q-Norm MQ, um diejenigen Rahmen der N Rahmen, die Varianzen oder Standardabweichungen in den In-Phase-Komponenten I und den Quadraturkomponenten Q über den entsprechenden gesamten Rahmen hinweg über einem vorbestimmten Varianz- oder Standardabweichung-Schwellwert aufweisen, zu beseitigen.

12. Abfragevorrichtung (20) nach Anspruch 11, wobei die Filtereinrichtung konfiguriert ist zum dynamischen Bestimmen der Varianz oder der Standardabweichungen oder des entsprechenden Schwellwerts durch das Bestimmen eines anfänglichen Schwellwerts als der Varianz oder der Standardabweichung der In-Phase-Komponenten I und der Quadraturkomponenten Q in einem bestimmten der N Rahmen und das Bestimmen des Schwellwerts als der Varianz oder der Standardabweichungen der In-Phase-Komponenten I und der Quadraturkomponenten Q in einem direkt auf den bestimmten Rahmen folgenden Rahmen, wenn diese kleiner als die Varianz oder die Standardabweichung in dem bestimmten Rahmen sind.

**13.** System für das Überwachen eines Umgebungsparameters, umfassend:

eine Abfragevorrichtung (20) gemäß einem der vorstehenden Ansprüche, und
eine Schallwellen-Sensorvorrichtung (10), die kommunikativ mit der Abfragevorrichtung gekoppelt ist, wobei die Schallwellen-Sensorvorrichtung (10) insbesondere eine passive Oberflächen-Schallwellen-Sensorvorrichtung ist und der Umgebungsparameter insbesondere die Temperatur, die Dehnung, der Druck oder das Drehmoment einer Drehachse ist.

**Revendications**

**1.** Dispositif d'interrogation (20) pour une interrogation d'un capteur à ondes acoustiques (10), comprenant

une antenne de transmission (21) configurée pour transmettre (101) un signal radiofréquence d'interrogation au capteur à ondes acoustiques (10) ;
une antenne de réception (22) configurée pour recevoir un signal radiofréquence de réponse (102) du capteur à ondes acoustiques (10) ; et
un moyen de traitement (24) configuré pour
déterminer (103) les composantes en phase I et les composantes de quadrature Q du signal radiofréquence de réponse reçu (102) dans chacune de N trames consécutives du signal radiofréquence de réponse (102), N consistant en un entier supérieur à 1, dans lequel chacune des N trames comprend X points d'échantillonnage ;
déterminer les moduli |Y| de chacune des paires des composantes en phase I et des composantes de quadrature Q déterminées ;
déterminer (104) une première norme M selon les moduli déterminés IYI ;
déterminer (105) une première fonction de pondération W selon la première norme M déterminée et les moduli déterminés IYI ;
déterminer les composantes en phase I et les composantes de quadrature Q d'une N+1ème trame du signal radiofréquence de réponse reçu, la N+1ème trame comprenant X points d'échantillonnage du signal radiofréquence de réponse reçu (102) ;
déterminer les moduli |Y| de chacune des paires des composantes en phase I et des composantes de quadrature Q déterminées ; **caractérisé par**
une application (106) de la première fonction de pondération W aux moduli déterminés |Y| du signal radiofréquence de réponse reçu (102) dans la N+1ème trame pour obtenir des moduli pondérés |Y|w du signal radiofréquence de réponse reçu (102) pour la N+1ème trame.

**2.** Dispositif d'interrogation (20) pour une interrogation d'un capteur à ondes acoustiques (10), comprenant

une antenne de transmission (22) configurée pour transmettre (101) un signal radiofréquence d'interrogation au capteur à ondes acoustiques (10) ;
une antenne de réception (21) configurée pour recevoir un signal radiofréquence de réponse (102) du capteur à ondes acoustiques (10) ; et
un moyen de traitement (24) configuré pour
déterminer (103) les composantes en phase I et les composantes de quadrature Q du signal radiofréquence de réponse reçu (102) dans chacune de N trames consécutives du signal radiofréquence de réponse (102), N consistant en un entier supérieur à 1, dans lequel chacune des N trames comprend X points d'échantillonnage ;
déterminer une première norme I MI selon les composantes en phase déterminées I ;
déterminer une première norme Q MQ selon les composantes de quadrature déterminées Q ;
déterminer (105) une première fonction de pondération I WI selon la première norme I MI déterminée et les composantes en phase déterminées I ;
déterminer une première fonction de pondération Q WQ selon la première norme Q MQ déterminée et les composantes de quadrature déterminées Q ;
déterminer les composantes en phase I et les composantes de quadrature Q d'une N+1ème trame du signal radiofréquence de réponse reçu (102), la N+1ème trame comprenant X points d'échantillonnage du signal radiofréquence de réponse reçu (102) ;
appliquer la première fonction de pondération I WI aux composantes en phase déterminées I du signal radiofréquence de réponse reçu (102) dans la N+1ème trame pour obtenir des composantes en phase pondérées Iw du signal radiofréquence de réponse reçu (102) pour la N+1ème trame ; et **caractérisé par**
une application de la première fonction de pondération Q WQ aux composantes de quadrature déterminées Q du signal radiofréquence de réponse reçu (102) dans la N+1ème trame pour obtenir des composantes de quadrature pondérées Qw du signal radiofréquence de réponse reçu (102) pour la N+1ème trame.

3. Le dispositif d'interrogation (20) selon la revendication 1, dans lequel le moyen de traitement (24) est configuré en outre pour

déterminer les composantes en phase I et les composantes de quadrature Q du signal radiofréquence de réponse reçu dans une N+2ème trame du signal radiofréquence de réponse (102), la N+2ème trame comprenant X points d'échantillonnage du signal radiofréquence de réponse reçu (102) ;
déterminer les moduli |Y| de chacune des paires des composantes en phase I et des composantes de quadrature Q déterminées de la N+2ème trame ;
déterminer une deuxième norme M selon les moduli déterminés |Y| de la 2ème à la N+1ème trame sans utiliser les moduli déterminés |Y| de la première trame des N trames ;
déterminer une deuxième fonction de pondération W selon la deuxième norme M déterminée et les moduli déterminés |Y| de la 2ème à la N+1ème trame sans utiliser les moduli déterminés |Y| de la première trame des N trames ; et
appliquer la deuxième fonction de pondération W aux moduli déterminés |Y| du signal radiofréquence de réponse reçu (102) dans la N+2ème trame pour obtenir des moduli pondérés |Y|w du signal radiofréquence de réponse reçu (102) pour la N+2ème trame.

4. Le dispositif d'interrogation (20) selon la revendication 2, dans lequel le moyen de traitement (24) est configuré en outre pour

déterminer les composantes en phase I et les composantes de quadrature Q du signal radiofréquence de réponse reçu (102) dans une N+2ème trame du signal radiofréquence de réponse (102), la N+2ème trame comprenant X points d'échantillonnage du signal radiofréquence de réponse reçu ;
déterminer une deuxième norme I MI selon les composantes en phase déterminées I de la 2ème à la N+2ème trame sans utiliser les composantes en phase I de la 1ère trame des N trames ;
déterminer une deuxième norme Q MQ selon les composantes de quadrature Q déterminées de la 2ème à la N+2ème trame sans utiliser les composantes de quadrature déterminées Q de la 1ère trame des N trames ;
déterminer une deuxième fonction de pondération I WI selon la deuxième norme I MI déterminée et les composantes en phase déterminées I de la 2ème à la N+2ème trame sans utiliser les composantes en phase déterminées I de la 1ère trame des N trames ;
déterminer une deuxième fonction de pondération Q WQ selon la deuxième norme Q M déterminée et les composantes de quadrature déterminées Q de la 2ème à la N+2ème trame sans utiliser les composantes de quadrature déterminées Q de la 1ère trame des N trames ;
appliquer la deuxième fonction de pondération I WI aux composantes en phase déterminées I du signal radiofréquence de réponse reçu (102) dans la N+2ème trame pour obtenir des composantes en phase pondérées Iw du signal radiofréquence de réponse reçu (102) pour la N+2ème trame ; et
appliquer la deuxième fonction de pondération Q WQ aux composantes de quadrature déterminées Q du signal radiofréquence de réponse reçu (102) dans la N+2ème trame pour obtenir des composantes de quadrature pondérées Qw du signal radiofréquence de réponse reçu (102) pour la N+2ème trame.

5. Le dispositif d'interrogation (20) selon la revendication 1 ou 3, dans lequel le moyen de traitement (24) est configuré pour déterminer (104) la première norme M selon l'équation

$$M = \sum_{n=1}^{N} \sum_{x=1}^{X} \frac{|Y_n(\omega_x)|}{NX}$$

dans lequel |Yn(ωx)| fait référence au modulus des composantes en phase I et des composantes de quadrature Q pour le xième point d'échantillonnage et la nième trame.

6. Le dispositif d'interrogation (20) selon la revendication 5, dans lequel le moyen de traitement (24) est configuré pour déterminer (105) la première fonction de pondération selon l'équation

$$W(\omega_x) = \sum_{n=1}^{N} Y_n(\omega_n)$$

**7.** Le dispositif d'interrogation (20) selon l'une des revendications 1, 3, 5 et 6, dans lequel le moyen de traitement (24) est configuré en outre pour appliquer une fonction de densité gaussienne aux moduli pondérés obtenus |Y|w.

**8.** Le dispositif d'interrogation (20) selon la revendication 2 ou 4, dans lequel le moyen de traitement (24) est configuré pour déterminer (104) la première norme I MI selon l'équation

$$M^I = \sum_{n=1}^{N} \sum_{x=1}^{X} \frac{I_n(\omega_x)}{NX}$$

dans lequel In($\omega$x) fait référence à la composante en phase pour le xième point d'échantillonnage et la nième trame et pour déterminer la première norme Q MQ selon l'équation

$$M^Q = \sum_{n=1}^{N} \sum_{x=1}^{X} \frac{Q_n(\omega_x)}{NX}$$

dans lequel Qn($\omega$x) fait référence à la composante de quadrature pour le xième point d'échantillonnage et la nième trame.

**9.** Le dispositif d'interrogation (20) selon la revendication 8, dans lequel le moyen de traitement (24) est configuré pour déterminer la première fonction de pondération I WI selon l'équation

$$W^I(\omega_x) = \sum_{n=1}^{N} \frac{I_n(\omega_n)}{NM^I}$$

et la première fonction de pondération Q WQ selon l'équation

$$W^Q(\omega_x) = \sum_{n=1}^{N} \frac{Q_n(\omega_n)}{NM^Q}$$

**10.** Le dispositif d'interrogation (20) selon l'une des revendications 2, 4, 8 et 9, dans lequel le moyen de traitement (24) est configuré en outre pour
calculer des moduli pondérés |Y|w pour les composantes en phase pondérées obtenues Iw du signal radiofréquence de réponse reçu (102) pour la N+1ème trame et les composantes de quadrature pondérées obtenues Qw du signal radiofréquence de réponse reçu (102) pour la N+1ème trame, et appliquer une fonction de densité gaussienne aux moduli pondérés calculés |Y|w.

**11.** Le dispositif d'interrogation (20) selon l'une des revendications précédentes, comprenant en outre un moyen de filtrage configuré pour filtrer le signal radiofréquence de réponse reçu (102) avant une détermination soit de la première norme M, soit de la première I MI et la première norme Q MQ, afin d'éliminer de telles trames des N trames qui présentent des variances ou des dérives standard dans les composantes en phase I et les composantes de quadrature Q sur la trame entière respective, qui dépassent un seuil de variance ou de dérive standard prédéterminé.

12. Le dispositif d'interrogation (20) selon la revendication 11, dans lequel le moyen de filtrage est configuré pour déterminer dynamiquement la variance ou les dérives standard, ou le seuil correspondant, en déterminant un seuil initial comme la variance ou la dérive standard des composantes en phase I et des composantes de quadrature Q dans une particulière des N trames, et en déterminant le seuil comme la variance ou la dérive standard des composantes en phase I et des composantes de quadrature Q dans une trame suivant directement la trame particulière, si celle-ci est plus petite que la variance ou la dérive standard dans la trame particulière.

13. Système de surveillance d'un paramètre ambiant, comprenant

un dispositif d'interrogation (20) selon l'une des revendications précédentes ; et
un dispositif de capteur à ondes acoustiques (10) couplé en communication au dispositif d'interrogation,
dans lequel le dispositif de capteur à ondes acoustiques (10), en particulier, est un dispositif de capteur à ondes acoustiques à surface passive et le paramètre ambiant, en particulier, est une température, une tension, une pression ou un couple d'un axe de rotation.

FIG. 1

FIG. 2

FIG. 3

**EP 3 949 120 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2010250170 A